# EUROPEAN PATENT APPLICATION

(11) **EP 1 783 776 A1**
(43) Date of publication of application: **09.05.2007**
(21) Application number: 06003921.1
(22) Date of filing: 27.02.2006
(51) Int. Cl.: G11C 11/16

(54) **Semiconductor memory device**

(30) Priority: 31.10.2005 JP 2005317215
(71) Applicant: KABUSHIKI KAISHA TOSHIBA, Tokyo 105-8001 (JP)
(72) Inventor: Inaba, Tsuneo, Minato-ku Tokyo 105-8001 (JP)
(74) Representative: HOFFMANN EITLE

(57) **Abstract**

In a writing method of a semiconductor memory device according to an aspect of the present invention, writing is carried out by using a magnetic field generated by a write current that flows through a write line (WBL,WWL) in such a manner that one end of the write line (WBL,WWL) is established in a floating state, charting of a write line (WBL,WWL) is started from a first power supply line Vdd via the other end of the write line (WBL,WWL), one end of the write line (WBL,WWL) is connected to a second power supply line (Vss) after charging has been started, a write current is supplied to the write line (WBL,WWL), and writing is carried out.

## Description

The present invention relates to a writing method of a semiconductor device, and in particular, of a magnetic random access memory (MRAM).

An MRAM is provided as a semiconductor memory device utilizing a magneto-resistive element having a magneto-resistive effect, for example, a magnetic tunneling junction (MTJ) element as a memory element. The MRAM is noticed as a novel memory device having its features such as high speed, high density, and high reliability in spite of the fact that it is nonvolatile.

The MTJ element has a stacked structure which consists of a ferromagnetic material/an insulating material/a ferromagnetic material. A tunnel current flows through an insulating material when a voltage is applied between two ferromagnetic materials. At this time, a resistance value changes in response to a relative angle of magnetization directions of the two ferromagnetic materials due to a TMR (tunneling magneto resistive) effect.

For example, the resistance value of the MTJ is obtained as the smallest value when the magnetization directions of the two ferromagnetic materials are identical (parallel) to each other. Conversely, the resistance value is obtained as the greatest value when the magnetization directions of the two ferromagnetic materials are opposite (inversely parallel) to each other.

By utilizing this phenomenon, for example, 1-bit data is stored in the MTJ element while a state in which the MTJ resistance value is small is set to "0" and a state in which the value is great is set to "1".

Here, several writing systems in magnetic random access memories have been proposed from the viewpoint of low power consumption or precluding incorrect writing (for example, reference should be made to T. Tsuji, et al., "A 1.2V 1Mbit Embedded MRAM Core with Folded Bit-Line Array Architecture", Symposium on VLSI Circuits Digest of Technical Papers, Jun. 2004, pp. 450-453; J. Debrosse et al. "A 16 Mb MRAM Featuring Bootstrapped Write Drivers", Symposium On VLSI Circuits Digest of Technical Papers, Jun. 2004, pp. 454-457).

In any writing method also, in common, a write operation is carried out by performing magnetizing inversion of a free layer of an MTJ element using a magnetic field generated by a current flowing through a writing wire.

Here, let us consider a write current waveform when a write operation is started. A time interval for a desired current value to be reached after supplying a write current, a so-called current rise time is a time interval required to charge a path in which a write current flows. This time interval depends on an RC product of the current path.

In these writing systems, there is a problem that a rise speed of a waveform of the write current is low, and a writing speed cannot be increased.

In a semiconductor memory device writing method according to an aspect of the present invention, writing is carried out by using a magnetic field generated by a write current that flows through a write line, in such a manner that one end of the write line is established in a floating state; charging of the writing line is started via the other end of the write line from a first power supply line; one end of the write line is connected to a second power supply line after he charging has been started; and the writing is carried out while the write current flows through the write line.

In a semiconductor memory device writing method according to an aspect of the present invention, writing is carried out by using a magnetic field generated by a write current that flows through a write line, in such a manner that charging of the write line is started via both of one end and the other end of the write line from a first power supply line; one end of the write line is connected to a second power supply line after the charging has been started; and the writing is carried out while the write current flows through the write line.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a diagram showing an outline of an aspect of the present invention;
FIG. 2 is a diagram showing an MRAM according to an aspect of the invention;
FIG. 3 is a diagram showing an MRAM relating to a writing method according to a first embodiment;
FIG. 4 is a waveform chart showing the writing method according to the first embodiment;
FIG. 5 is a waveform chart showing the writing method according to the first embodiment;
FIG. 6 is a waveform chart showing a writing method according to a comparative example of the first embodiment;
FIG. 7 is a view showing an MRAM relating to a writing method according to a second embodiment;
FIG. 8 is a waveform chart showing the writing method according to the second embodiment;
FIG. 9 is a view showing an MRAM relating to a writing method according to a third embodiment;
FIG. 10 is a waveform chart showing the writing method according to the third embodiment;
FIG. 11 is a view showing an MRAM relating to a writing method according to a fourth embodiment;
FIG. 12 is a waveform chart showing the writing method according to the fourth embodiment;
FIG. 13 is a waveform chart showing the writing method according to the fourth embodiment;
FIG. 14 is a waveform chart showing a writing method according to a comparative example of the fourth embodiment;
FIG. 15 is a circuit diagram showing an example of a logic circuit which generates a control signal SWN_R;
FIG. 16 is a waveform chart showing an operation of the logic circuit shown in FIG. 15;
FIG. 17 is a circuit diagram showing an example of a logic circuit which generates a control signal SWN_R;
FIG. 18 is a waveform chart showing an operation of the logic circuit shown in FIG. 17;
FIG. 19 is a view showing an example of a memory cell array;
FIG. 20 is a view showing an example of a memory cell array;
FIG. 21 is a circuit diagram depicting an example of a logic circuit which generates a control signal SWN_Ri ;
FIG. 22 is a circuit diagram depicting an example of a logic circuit which generates a control signal SWN_Ri;
FIG. 23 is a view showing an example of a cell array having a redundancy cell array;
FIG. 24 is a view showing an example of a cell array having a redundancy cell array;
FIG. 25 is a circuit diagram depicting an example of a logic circuit which generates a control signal SWN_R; and
FIG. 26 is a circuit diagram depicting an example of a logic circuit which generates a control signal SWN_R.

A semiconductor memory device of aspect of the present invention will be described below in detail with reference to the accompanying drawings.

### 1. Outline

An aspect of the present invention relates to a magnetic random access memory which carries out writing by using a magnetic field (current magnetic field) generated by a write current that flows through a write line.

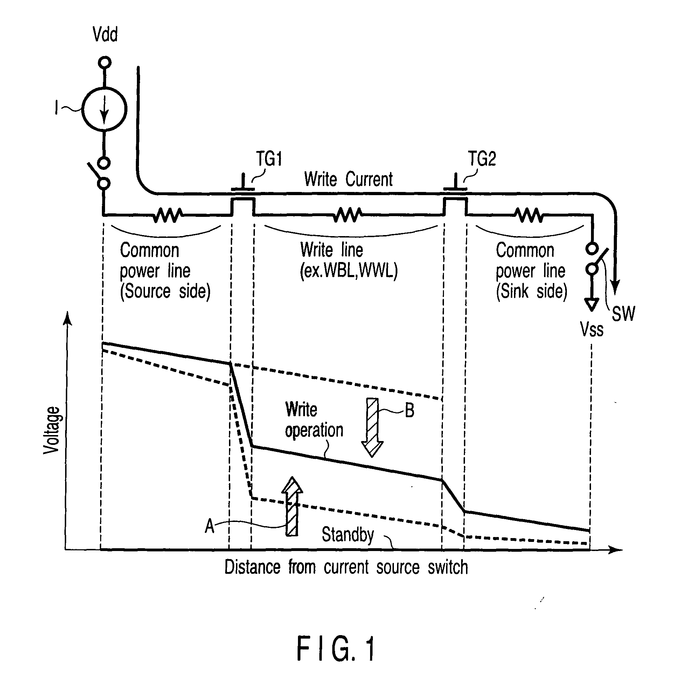

In such a magnetic field random access memory, as shown in FIG. 1, a write current is generated by, for example, a constant current source I, and flows from a path of a source side common power line, a transfer gate TG1, a write line, a transfer gate TG2 to a sink side common power line.

However, when a write operation is started from a standby state, a transient current flows for the sake of charging of a whole path of the write current at an initial stage, and a predetermined period is required for a steady state to be established (change A). This period corresponds to a period required for each node to be charged up to an electric potential of the steady state. However, a current driving force is low because a transfer gate (MOS transistor) TG1 between the source side common power line and the write line is driven as a source follower. In addition, charging of the whole path is carried out while a current is supplied from a current source to a grounding terminal when a transfer gate (MOS transistor) TG2 between the sink side common power line and the write line is turned ON. Thus, this period is comparatively long, and has precluded an increase in write speed.

Therefore, in the aspect of the present invention, for example, one end of a write line, at an initial stage of a write operation, is disconnected from a grounding terminal Vss by turning OFF a switch (MOS transistor) SW or a transfer gate (MOS transistor) TG2 serving as a sinker. In a state in which one end of the write line is established in a floating state, charging of the write line is started via the other end of the write line from a power supply terminal Vdd. Then, after a predetermined time interval has elapsed, the write line is connected to the grounding terminal Vss by turning ON the transfer gate TG2, and a write operation is executed by supplying a write current to the write line (change B).

According to such a writing method, a charging time is short because charging of a write path is carried out in a state in which the transfer gate TG2 is turned OFF. Further, a source electric potential of the transfer gate TG1 is higher than a grounding electric potential. The transfer gate TG2 has a higher current driving capability during operation than the transfer gate TG1. As a result, an electric potential difference between a drain and a source of the transfer gate TG1 can be greatly allocated immediately after the transfer gate TG2 has been switched from OFF to ON. In addition, the electric potential of each node of the write path can be charged or discharged at a high speed until a steady state has been established. For these two reasons, a high speed write operation can be made.

### 2. Embodiments

Now, a description will be given with respect to some embodiments which seem to be the best.

### (1) Outline of magnetic random access memory

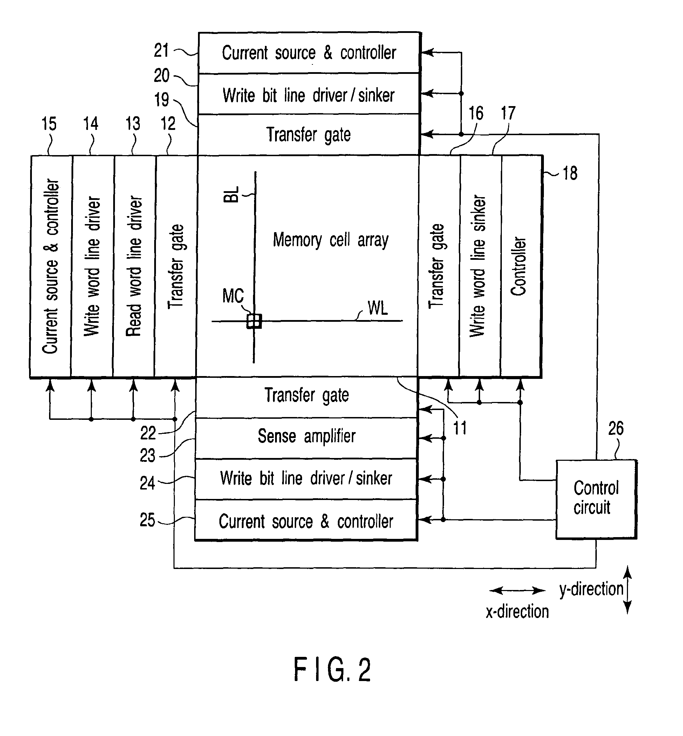

FIG. 2 shows an outline of a magnetic random access memory.

A memory cell array 11 has memory cells MC. The memory cells MC are allocated at a cross point between a write word line WL which extends in the x direction and a write bit line BL which extends in the y direction.

A transfer gate 12, a readout word line driver 13, a write word line driver 14, and a current source & controller 15 are allocated at one end of the write word line WL. The current source & controller 15 generates a write/readout current and controls operations of the transfer gate 12, the readout word line driver 13, and the write word line driver 14.

A transfer gate 16, a write word line sinker 17, and a controller 18 are allocated at the other end of the write word line WL. The controller 18 controls operations of the transfer gate 16 and the write word line sinker 17.

A transfer gate 19, a write bit line driver/sinker 20, and a current source & controller 21 are allocated at one end of the write bit line BL. The current source controller 21 generates a write current and controls operations of the transfer gate 19 and the write bit line driver/sinker 20.

A transfer gate 22, a sense amplifier 23, a write bit line driver/sinker 24, and a current source & controller 25 are allocated at the other end of the write bit line BL. The current source & controller 25 generates a write current and controls operations of the transfer gate 22, the sense amplifier 23, and the write bit line driver/sinker 24.

The control circuit 26 generates a control signal required for a write/readout operation and controls a flow of the whole write/readout operation.

In this example, only a write current traveling in one direction flows through a write word line WL, and a write current traveling in one direction or in the other direction flows through the-best a write bit line BL in response to a value of write data.

However, for example, as in a toggle writing system (non-patent document 1), a write current always traveling in one direction may flow the write word line WL and the write bit line BL regardless of the value of the write data.

In addition, for example, as in a writing system using first and third quadrants of an asteroid curve, a write current traveling in one direction or in the other direction may flow through the write word line WL and the write bit line BL in response to the value of the wrote value.

Further, the memory cell array 11 may be composed of a plurality of sub-arrays or a plurality of blocks. In a memory chip, a memory cell array shown in FIG. 2 and a circuit group connected to this array may be incorporated in plurality.

### (2) First embodiment

### A. Circuit construction

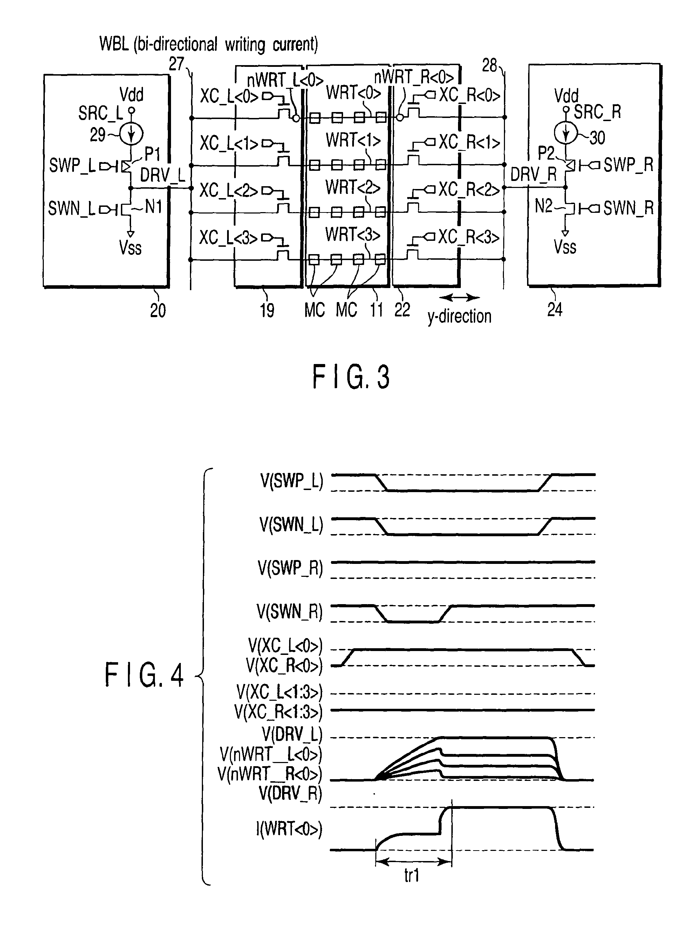

FIG. 3 shows essential portions of a magnetic random access memory to which a writing method according to a first embodiment is applied.

According to the first embodiment, the writing method according to the aspect of the invention is applied to a write current that flows through the write bit line BL shown in FIG. 2. The write word line is omitted here.

Memory cells MCs are allocated in an arrayed shape, and configure a memory cell array 11. Write bit lines WRT<0>, WRT<1>, WRT<2>, and WRT<3> extend in the y direction in the memory cell array 11.

One end of each of the write bit lines WRT<0>, WRT<1>, WRT<2>, and WRT<3> is connected to a common power supply line 27 via a transfer gate 19 serving as a selector switch. The common power supply line 27 is connected to a write bit line driver/sinker 20.

ON/OFF operation of the transfer gate 19 is controlled by column selecting signals XC_L<0>, XC_L<1>, XC_L<2>, and XC_L<3>.

The write bit line driver/sinker 20 is composed of a constant current source 29 connected in series between a power supply terminal Vdd and a grounding terminal Vss, a P-channel MOS transistor P1, and an N-channel MOS transistor N1.

The constant current source 29 generates a constant current SRC_L. A control signal SWP_L is inputted to a gate of the P-channel MOS transistor P1, and a control signal SWN_L is inputted to a gate of the N-channel MOS transistor N1.

The other end of each of the write bit lines WRT<0>, WRT<1>, WRT<2>, and WRT<3> is connected to a common power supply line 28 via a transfer gate 22 serving as a selector switch.

ON/OFF operation of the transfer gate 22 is controlled by column selecting signals XC_R<0>, XC_R<1>, XC_R<2>, and XC_R<3>.

The write bit line driver/sinker 24 is composed of a constant current source 30 connected in series between a power supply terminal Vdd and a grounding terminal Vss, a P-channel MOS transistor P2, and an N-channel MOS transistor N2.

The constant current source 30 generates a constant current SRC_R. A control signal SWP_R is inputted to a gate of the P-channel MOS transistor P2, and a control signal SWN_R is inputted to a gate of the N-channel MOS transistor N2.

### B. Operation

### a. First example

FIG. 4 shows a first example of the writing method according to the first embodiment.

Here, a description will be given with respect to a case where a write bit line WRT<0> in column 0 shown in FIG. 3 is selected, and then, a write current traveling from a write bit line driver/sinker 20 to a write bit line driver/sinker 24 flows through the write bit line WRT<0>.

First, from a standby state, voltage levels V(XC_L<0>), V(XC_R<0>) of column selecting signals XC_L<0>, XC_R<0> are changed from "L (low)" to "H (high)", and the write bit line WRT<0> is electrically connected to the write bit line driver/sinkers 20 and 24.

Voltage levels V(XC_L<1:3>) and V(XC_R<1:3>) of other column selecting signals XC_L<1:3> and XC_R<1:3> are kept to be "L".

Then, voltage levels V(SWP_L), V(SWN_L), and V(SWN_R) of the control signals SWP_L, SWN_L, and SWN_R are changed from "H" to "L", and the voltage level V(SWP_R) of the control signal SWP_R is kept to be "H", whereby the P-channel MOS transistor P1 is turned ON, and the other MOS transistors P2, N1, and N2 are turned OFF.

At this time, nodes DRV_L, nWRT_L<0>, nWRT_R<0>, and DRV_R are charged by a constant current from the constant current source 29, and their voltage levels V(DRV_L), V(nWRT_L<0>), V(nWRT_R<0>), and V(DRV_R) gradually rise.

After the electric potential of the node nWRT_L<0> has become sufficiently high, the voltage level V(SWN_R) of the control signal SWN_R is changed from "L" and "H", and the N-channel MOS transistor N2 is turned ON.

As a result, a write current I(WRT<0>) traveling from the write bit driver/sinker 20 to the write bit line driver/sinker 24 flows through the write bit line (WRT<0>).

At this time, a source electric potential of the source side transfer gate 19 is higher than that of the sink side transfer gate 22. Thus, the sink side transfer gate 22 has a higher current driving capability than the source side transfer gate 19. As a result, the electric potential of the node nWRT_L<0> is discharged at a high speed, and is lowered. An electric potential difference between a drain and a source of the source side transfer gate 19 is allocated in sufficient amount for supplying a steady current.

In this way, after charging of the write bit line WRT<0> has been started, a write current is supplied to the write bit line WRT<0>, whereby a period tr1 for a steady state to be established after the flowing of the write current I(WRT<0>) can be reduced, and a high speed write operation can be achieved.

### b. Second example

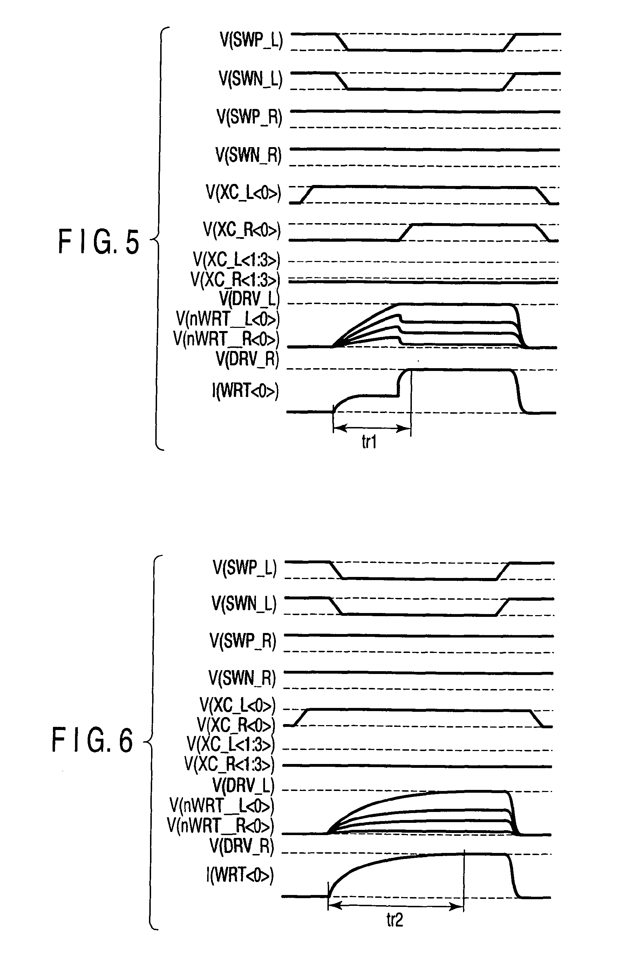

FIG. 5 shows a second example of the writing method according to the first embodiment.

As in the first example described above, a description will be given with respect to a case where a write current traveling from the write bit line driver/sinker 20 to the write bit line driver sinker 24 flows through the write bit line WRT<0> shown in FIG. 3.

First, from a standby state, a voltage level V(XC_L<0>) of the column selecting signal XC_L<0> is changed from "L" to "H", and one end of the write bit line WRT<0> is electrically connected to the write bit line driver/sinker 20.

At this time, voltage levels V(XC_L<1:3>) and V(XC_R<0:3> of the other column selecting signals XC_L<1:3> and XC_R<0:3> are kept to be "L".

Then, voltage levels V(SWP_L) and V(SWN_L) of the control signals SWP_L and SWN_L are changed from "H" to "L", and voltages levels V(SWP_R) and V(SWN_R) of the control signals SWP_R and SWN_R are kept to be "H", whereby the P-channel MOS transistor P1 and the N-channel MOS transistor N2 are turned ON, and the other MOS transistors P1 and N1 are turned OFF.

At this time, nodes DRV_L, nWRT_L<0>, nWRT_R<0>, and DRV_R are changed by a constant current from the constant current source 29, and their voltage levels V(DRV_L), V(nWRT_L<0>), V(nWRT_R<0>), and V(DRV_R) gradually rise.

After the electric potential of the node nWRT_L<0> has become sufficiently high, the voltage level V(XC_R<0>) of the column selecting signal XC_R<0> is changed from "L" to "H", and the other end of the write bit line WRT<0> is electrically connected to the write bit line driver/sinker 24.

As a result, a write current I(WRT<0>) traveling from the write bit line driver/sinker 20 to the write bit line driver/sinker 24 flows through the write bit line WRT<0>.

At this time, a source electric potential of the source side transfer gate 19 is higher than that of the sink side transfer gate 22. Thus, the sink side transfer gate 22 has a higher current driving capability than the source side transfer gate 19. As a result, an electric potential of the node nWRT_L<0> is discharged at a high speed, and is lowered. An electric potential difference between a drain and a source of the source side transfer gate 19 is allocated in sufficient amount for supplying a steady current.

In this way, after charging of the write bit line WRT<0> has been started, a write current is supplied to the write bit line WRT<0>, whereby a period tr1 for a steady state to be established after the flowing of the write current I(WRT<0>) can be reduced, and a high speed write operation can be achieved.

### c. Advantageous effect

A waveform shown in FIG. 6 is provided as an example in the case where a write current is supplied immediately after a standby state without charging a write bit line while a sink side transfer gate 22 is turned OFF. In this case, a whole path is charged while a write current is supplied by the source side transfer gate 19 having a low current driving capability because of a source follower operation. Thus, a period tr2 from a standby state to a steady state in which a waveform of the write current rises becomes very long.

According to the aspect of the invention, a write operation speed can be increased as has already been described.

In consideration of the whole write operation, in general, the period tr1 is started after word line activation. However, this timing is set at the same as word line activation or earlier than word line activation, thereby enabling further speedy operation.

In the examples shown in FIGS. 4 and 5, while a write current has been supplied from the write bit line driver/sinker 20 to the write bit line driver/sinker 24, a similar writing method can be applied in the case where a write current is supplied in a direction opposite to the above direction.

### C. Summary

According to such a novel writing method, a magnetic random access memory writing speed can be increased.

### (3) Second embodiment

### A. Circuit construction

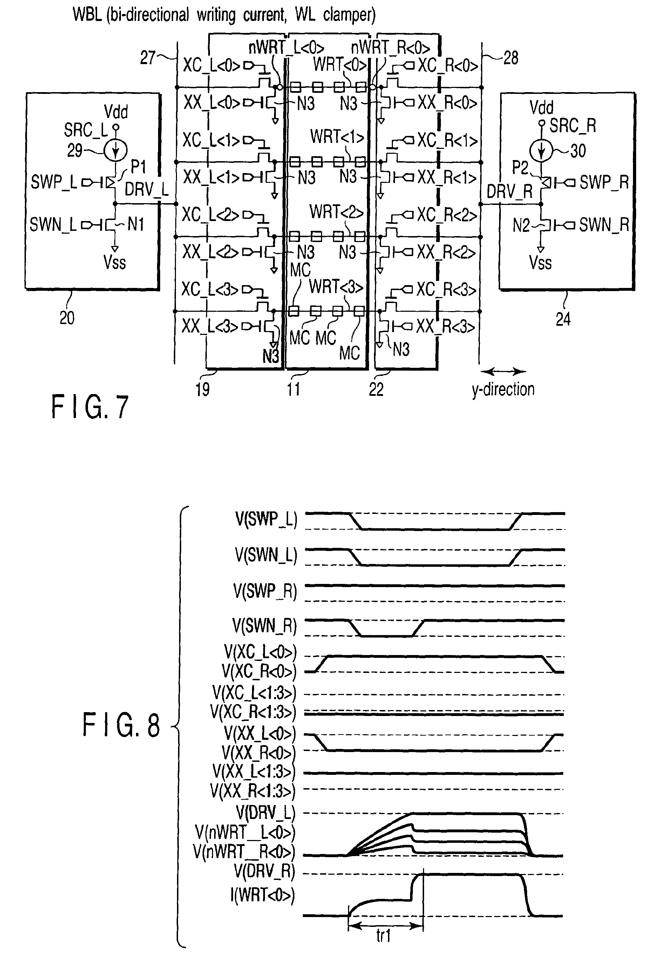

FIG. 7 shows essential portions of a magnetic random access memory to which a writing method according to a second embodiment is applied.

In the second embodiment, as in the first embodiment, the writing method according to the aspect of the invention has been applied to a write current that flows through the write bit line BL shown in FIG. 2. The write word line is omitted here.

The second embodiment is featured in that an N-channel MOS transistor N3 serving as a clamping circuit has been connected to both ends of a write bit line WRT<0:3>, respectively.

ON/OFF operation of the N-channel MOS transistor N3 serving as a clamping circuit is controlled by control signals XX_L<0:3> and XX_R<0:3>.

One of the materials of this clamping circuit is to supply a grounding electric potential Vss from the both ends to the write bit line WRT<0:3> in a standby state, thereby reliably fixing an electric potential of a write bit line to a grounding electric potential. In addition, an electric potential of a deselected write bit line while in write operation can also be reliably fixed to a grounding electric potential.

Other constituent elements are identical to those according to the first embodiment, and a duplicate description is omitted here.

### B. Operation

FIG. 8 shows the writing method according to the second embodiment.

Here, a description will be given with respect to a case where a write bit line WRT<0> in column 0 shown in FIG. 7 is selected, and then, a write current traveling from the write bit line driver/sinker 20 to the write bit line driver/sinker 24 flows through the write bit line WRT<0>.

First, from a standby state, voltage levels V(XX_L<0> and V(XX_R<0>) of clamping control signals XX_L<0> and XX_R<0> are changed from "H" to "L", and the selected write bit line WRT<0> is disconnected from a grounding point.

With respect to other deselected write bit line WRT<1:3>, voltage levels V(XX_L<1:3>) and V(XX_R<1:3>) of the clamping signals XX_L<1:3> and XX_R<1:3> are kept to be "H", and thus, this bit line is kept to be connected to the grounding point via the clamping circuit.

At the substantially same time, from a standby state, voltage levels V(XC_L<0>) and V(XC_R<0>) of column selecting signals XC_L<0> and XC_R<0> are changed from "L" to "H", and the selected write bit line WRT<0> is electrically connected to the write bit line drivers/sinkers 20 and 24.

Voltage levels V(XC_L<1:3>) and V(XC_R<1:3) of other column selecting signals XC_L<1:3> and XC_R<1:3> are kelp to be "L".

Then, voltage levels V(SWP_L), V(SWN_L), and V (SWN_R) of the control signals SWP_L, SWN_L, and SWN_R are changed from "H" to "L", and the voltage level V(SWP_R) of the control signal SWP_R is kept to be "H", whereby the P-channel MOS transistor P1 is turned ON, and the other MOS transistors P2, N1, and N2 are turned OFF.

At this time, nodes DRV_L, nWRT_L<0>, nWRT_R<0>, and DRV_R are charged by a constant current from the constant current source 29, and their voltage levels V(DRV_L), V(nWRT_L<0>), V(nWRT_R<0>), and V(DRV_R) gradually rise.

After an electric potential of the node nWRT_L<0> has become sufficiently high, the voltage level V(SNN_R) of the control signal SWN_R is changed from "L" to "H", and the N-channel MOS transistor N2 is turned ON.

As a result, a write current I(WRT<0>) traveling from the write bit line driver/sinker 20 to the write bit line driver/sinker 24 flows through the write bit line WRT<0>.

At this time, a source electric potential of the source side transfer gate 19 is higher than that of the sink side transfer gate 22. Thus, the sink side transfer gate 22 has a higher current driving capability than the source side transfer gate 19. As a result, an electric potential of the node nWRT_L<0> is discharged at a high speed, and is lowered. An electric potential difference between a drain and a source of the source side transfer gate 19 is allocated in sufficient amount for supplying a steady current.

In this way, after charging of the write bit line WRT<0> has been carried out, a write current is supplied to the write bit line<0>, whereby a period tr1 for a steady state to be established after the flowing of the write current I (WRT<0>) can be reduced, and a high speed write operation can be achieved.

Then, when the voltage levels V(SWP_L) and V(SWN_L) of the control signals SWP_L and SWN_L are changed to "L" to "H", the P-channel MOS transistor P1 is turned OFF, and the N-channel MOS transistor N1 is turned ON. Thus, both ends of the write bit line WRT<0> are short-circuited at a grounding point via the N-channel MOS transistors N1 and N2, respectively.

In addition, when the voltage levels V(XC_L<0>) and V(XC_R<0>) of the column selecting signals XC_V<0> and XC_R<0> are changed from "H" to "L", all the write bit lines WRT<0:3> are electrically disconnected from the common power supply lines and the common power supply lines 27 and 28 are short-circuited at a grounding point.

At this time, the voltage levels V(XX_L<0>) and V(XX_R<R>) of the clamping control signals XX_L<0> and XX_R<0> are changed from "L" to "H", a grounding electric potential is applied to both ends of the write bit line WRT<0> via the clamping circuit, and a standby state is restored.

The above-described operation corresponds to the first example according to the first embodiment, and an operation of the second example according to the first embodiment can also be carried out.

### C. Summary

In such a novel writing method as well, a write speed of a magnetic random access memory can be increased.

In an example shown in FIG. 8, a write current has been supplied from the write bit line driver/sinker 20 to the write bit line driver/sinker 24, and such a writing method can be also applied in the cased where a write current is supplied in a direction opposite to the above direction.

### (4) Third embodiment

### A. Circuit construction

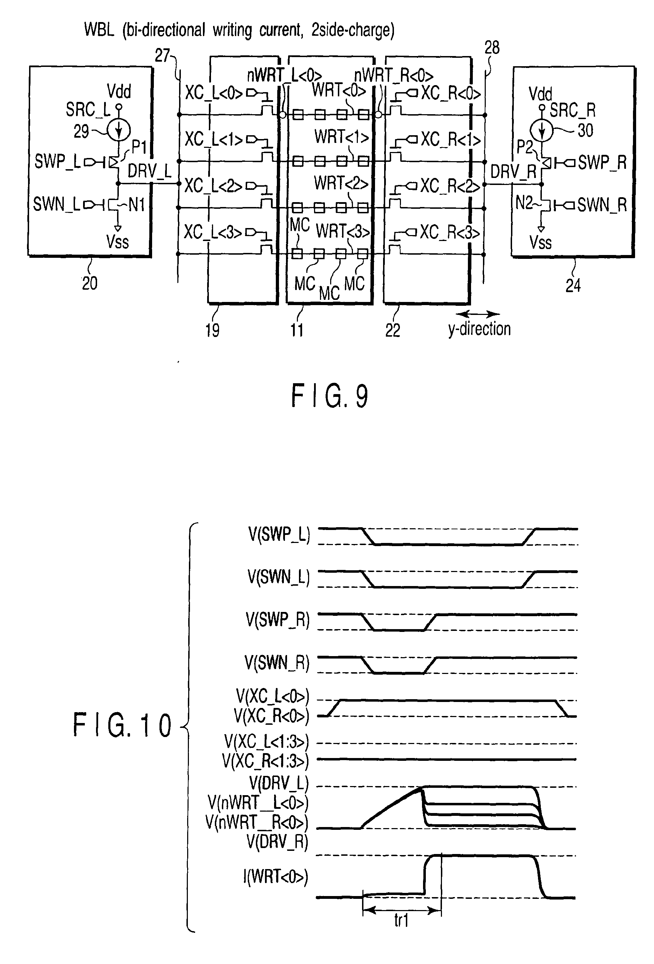

FIG. 9 shows essential portions of a magnetic random access memory to which a writing method according to a third embodiment is applied.

In the third embodiment also, as in the first embodiment, the writing method according to the aspect of the present invention has been applied to a write current that flows through the write bit line BL shown in FIG. 2. The write word line is omitted here.

The third embodiment is featured in that charging relevant to a selected write bit line WRT<0> is carried out at both ends of the write bit line WRT<0> instead of one end of the write bit line WRT<0>.

Namely, the third embodiment is featured by circuit operation, and is identical to the first embodiment in terms of the circuit configuration. A duplicated description is omitted here.

The clamping circuit according to the second embodiment can be applied to the magnetic random access memory according to the third embodiment.

### B. Operation

FIG. 10 shows the writing method according to the third embodiment.

Here, a description will be given with respect to a case where a write bit line WRT<0> in column 0 shown in FIG. 9 is selected, and then, a write current traveling from the write bit line driver/sinker 20 to the write bit line driver/sinker 24 flows through the write bit line WRT<0>.

First, from a standby state, voltage levels V(XC_L<0>) and V(XC_R<0>) of column selecting signals XC_L<0> and XC_R<0> are changed from "L" to "H", and the selected write bit line WRT<0> is electrically connected to the write bit line drivers/sinkers 20 and 24.

Voltage levels V(XC_L<1:3> and XC_R<1:3> of other column selecting signals XC_L<1:3> and XC_R<1:3> are kept to be "L".

Then, voltage levels V(SWP_L), V(SWN_L), V(SWP_R), and V(SWN_R) of the control signals SWP_L, SMN_L, SWP_R, and SWN_R are changed from "H" to "L", whereby the P-channel MOS transistors P1 and P2 are turned ON, and the N-channel MOS transistors N1 and N2 are turned OFF.

At this time, nodes DRV_L, nWRT_L<0>, nWRT_R<0>, and DRV_R are rapidly charged at both ends of the write bit line WRT<0> by a constant current from the constant current sources 29 and 30; and their voltage levels V(DRV_L), V(nWRT_L<0>), V(nWRT_R<0>), and V(DRV_R) rapidly rise.

After an electrical potential of the node nWRT_L<0> has become sufficiently high, the voltage levels V(SWP_R) and V(SWN_R) of the control signals SWP_R and SWN_R are changed from "L" to "H", the P-channel MOS transistor P2 is turned OFF, and the N-channel MOS transistor N2 is turned ON.

As a result, a write current I(WRT<0>) traveling from the write bit line driver/sinker 20 to the write bit line driver/sinker 24 flows through the write bit line WRT<0>.

At this time, a source electric potential of the source side transfer gate 19 is higher than that of the sink side transfer gate 22. Thus, the sink side transfer gate 22 has a higher current driving capability than the source side transfer gate 19. As a result, an electric potential of the node nWRT_L<0> is discharged at a high speed, and is lowered, and an electric potential difference between a drain and a source of the source side transfer gate 19 is allocated in sufficient amount for supplying a constant current.

In this way, after charging of the write bit line WRT<0> has been started, a write current is supplied to the write bit line WRT<0>, whereby a period tr1 for a steady state to be established after the flowing of the write current I(WRT<0>) can be reduced, and a high speed write operation can be achieved.

### C. Summary

In such a novel writing method, charging relevant to the selected write bit line is carried out at both ends, whereby a write speed of the magnetic random access memory can be further increased.

In an example shown in FIG. 10, a write current has been supplied from the write bit line driver/sinker 20 to the write bit line driver/sinker 24, and such a writing method can be also applied in the case where a write current is supplied in a direction opposite to the above direction.

### (5) Fourth embodiment

### A. Circuit construction

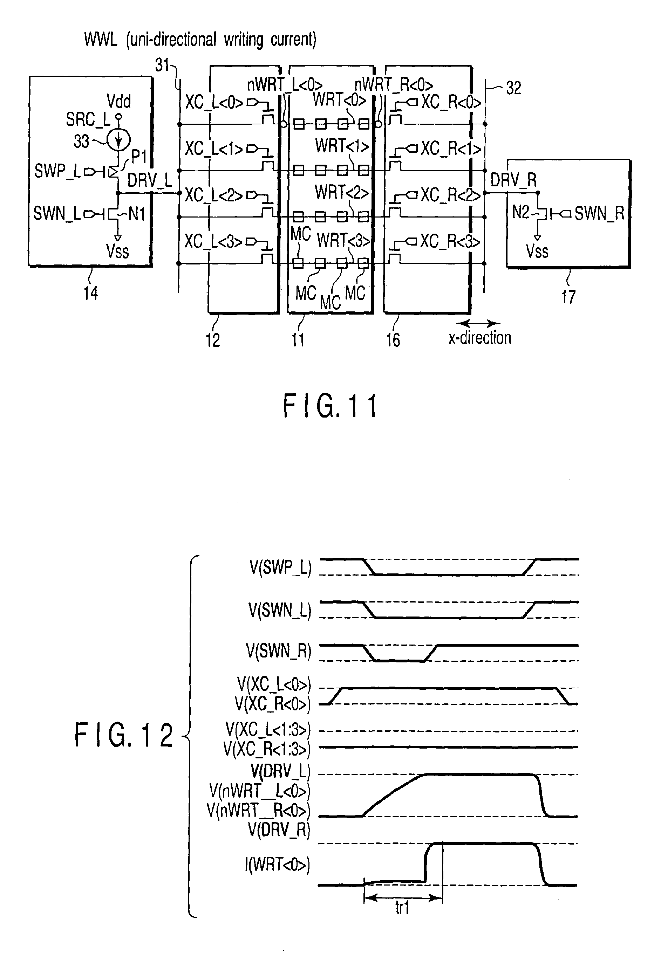

FIG. 11 shows essential portions of a magnetic random access memory to which a writing method according to a fourth embodiment is applied.

In the fourth embodiment, the writing method according to the aspect of the present invention has been applied to a write current that flows the write word line WL shown in FIG. 2 in which a current direction is only one direction. The write bit line is omitted here.

Memory cells MCs are allocated in an arrayed shape, and configure a memory cell array 11. Write word lines WRT<0>, WRT<1>, WRT<2>, and WRT<3> extend in the x direction in the memory cell array 11. One end of each of write word lines WRT<0>, WRT<1>, WRT<2>, and WRT<3> is connected to a common power supply line 31 via a transfer gate 12 serving as a selector switch. The common power supply line 31 is connected to a write word line driver 14.

ON/OFF operation of the transfer gate 12 is controlled by row selecting signals XC_L<0>, XC_L<1>, XC_L<2>, and XC_L<3>.

The write word line driver 14 is composed of a constant current source 33 connected in series between a power supply terminal Vdd and a grounding terminal Vss, a P-channel MOS transistor P1, and an N-channel MOS transistor N1.

The constant current source 33 generates a constant current SRC_L, a control signal SWP_L is inputted to a gate of the P-channel MOS transistor P1, and a control signal SWN_L is inputted to a gate of the N-channel MOS transistor N1.

The other end of each of the write word lines WRT<0> WRT<1>, WRT<2>, and WRT<3> is connected to a common power supply line 32 via a transfer gate 16 serving as a selector switch. The common power supply line 32 is connected to a write word line sinker 17.

ON/OFF operation of the transfer gate 16 is controlled by row selecting signal XC_R<0>, XC_R<1>, XC_R<2>, and XC_R<3>.

The write word line sinker 17 is composed of an N-channel MOS transistor N2 connected in series between the common power supply line 32 and the grounding terminal Vss. A control signal SWN_R is inputted to a gate of the N-channel MOS transistor N2.

### B. Operation

### a. First example

FIG. 12 shows a first example of the writing method according to the fourth embodiment.

Here, a description will be given with respect to a case where a write word line WRT<0> in row 0 shown in FIG. 11 is selected, and then, a write current traveling from the write word line driver 14 to the write word line sinker 17 flows through the write word line WRT<0>.

First, from a standby state, voltage levels V(XC_L<0>) and V(XC_R<0>) of row selecting signals XC_L<0> and XC_R<0> are changed from "L" to "H", and the write word line WRT<0> is electrically connected to the write word line driver 14.

Voltage levels V(XC_L<1:3>) and V(XC_R<1:3>) of other row selecting signals XC_L<1:3> and XC_R<1:3> are kept to be "L".

Then, voltage levels V(SWP_L), V(SWN_L), and V(SMN_R) of the control signals SWP_L, SWN_L, and SWN_R are changed from "H" to "L", whereby the P-channel MOS transistor P1 is turned ON, and the N-channel MOS transistors N1 and N2 are turned OFF.

At this time, nodes DRV_L, nWRT_L<0>, nWRT_R<0>, and DRV_R are charged by a constant current from the constant current source 33, and their voltage levels V(DRV_L), V(nWRT_L<0>), V(nWRT_R<0>), and V(DRV_R) gradually rise.

After an electric potential of the node nWRT_L<0> has become sufficiently high, the voltage level V(SWN_R) of the control signal SWN_R is changed from "L" to "H", and the N-channel MOS transistor N2 is turned ON.

As a result, a write current I(WRT<0>) traveling from the write bit driver 14 to the bit line sinker 17 flows through the write word line (WRT<0>).

At this time, a source electric potential of the source side transfer gate 12 is higher than that of the sink side transfer gate 16. Thus, the sink side transfer gate 16 has a higher current driving capability than the source side transfer gate 12. As a result, the electric potential of the node nWRT_L<0> is discharged at a high speed, and is lowered. An electric potential difference between a drain and a source of the source side transfer gate 12 is allocated in sufficient amount for supplying a steady current.

In this way, after charging of the write word line WRT<0> has been started, a write current is supplied to the write word line WRT<0>, whereby a period tr1 for a steady state to be established after the flowing of the write current I(WRT<0>) can be reduced, and a high speed write operation can be achieved.

### b. Second example

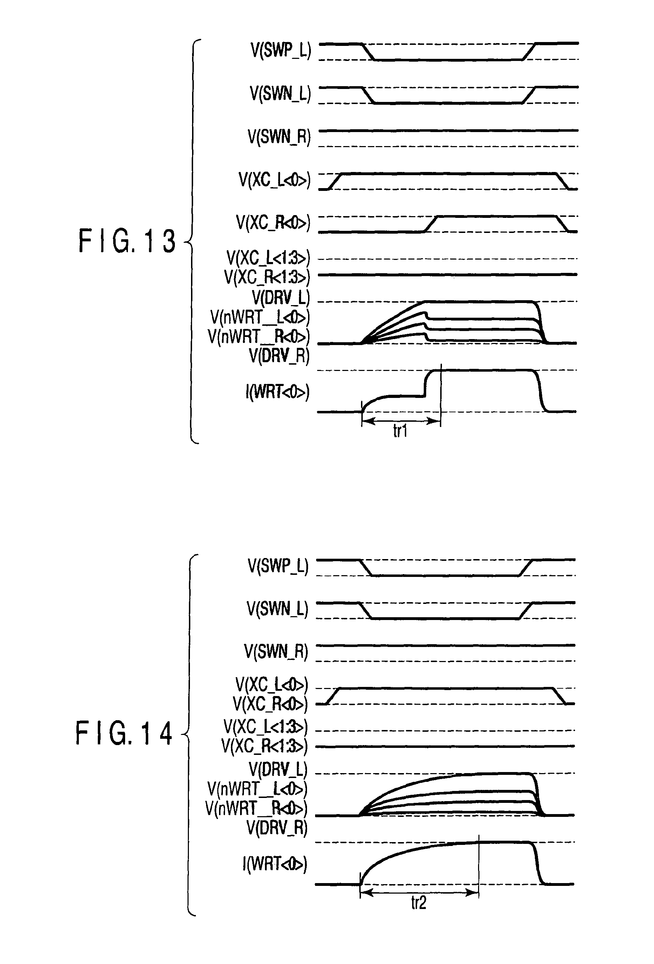

FIG. 13 shows a second example of the writing method according to the fourth embodiment.

As in the first example described above, a description will be given with respect to a case where a write current traveling from the write word line driver 14 to the write word line sinker 17 flows through the word line WRT<0> shown in FIG. 11.

First, from a standby state, the voltage level V(XC_L<0>) of the row selecting signal XC_L<0> is changed from "L" to "H", and one end of the write word line WRT<0> is electrically connected to the write word line driver 14.

At this time, the voltage levels V(XC_L<1:3>) and V(XC_R<0:3>) of the other row selecting signals XC_L<1:3> and XC_R<0:3> are kept to be "L".

Then, the voltage levels V(SWP_L) and V(SWN_L) of the control signals SWP_L and SWN_L are changed from "H" to "L", and the voltage level V(SWN_R) of the control signal SWN_R is kept to be "H", whereby the P-channel MOS transistor P1 and the N-channel MOS transistor N2 are turned ON, and the N-channel MOS transistor N1 is turned OFF.

At this time nodes DRV_L, nWRT_L<0>, nWRT_R<0>, and DRV_R are charged by a constant current from the constant current source 33, and their voltage levels V(DRV_L), V(nWRT_L<0>), V(nWRT_R<0>), and V(DRV_R) gradually rise.

An electric potential of the node nWRT_L<0> has become sufficiently high, the voltage level V(XC_R<0>) of the row selecting signal XC_R<0> is changed from "L" to "H", and the other end of the write word line WRT<0> is electrically connected to the write word line sinker 17.

As a result, a write current I(WRT<0>) traveling from the write word driver 14 to the write word line sinker 17 flows through the write bit line (WRT<0>).

At this time, a source electric potential of the source side transfer gate 12 is higher than that of the sink side transfer gate 16. Thus, the sink side transfer gate 16 has a higher current driving capability than the source side transfer gate 12. As a result, an electric potential of the node nWRT_L<0> is discharged at a high speed, and is lowered. An electric potential difference between a drain and a source of the source side transfer gate 12 is allocated in sufficient amount for supplying a steady current.

In this way, after charging of the write word line WRT<0> has been conducted, a write current is supplied to the write word line WRT<0>, whereby a period tr1 for a steady state to be established after the flowing of the write current I(WRT<0>) can be reduced, and a high speed write operation can be achieved, as in the example in FIG. 12.

### c. Advantageous effect

A waveform shown in FIG. 14 is provided as an example in the case where a write current is supplied immediately after a standby state without charging a write word line while the sink side transfer gate 16 is turned OFF. In this case, a whole path is charged while a write current is supplied by the source side transfer gate 12 having a low current driving capability because of a source follower operation. Thus, a period tr2 from a standby state to a steady state in which a waveform of the write current rises becomes very long.

According to the aspect of the present invention, a write operation speed can be increased as has already been described.

### C. Summary

According to such a novel writing method, a write speed of a magnetic random access memory can be increased.

### (6) Others

While the first to fourth embodiments have described separately a case where the aspect of the present invention has been applied to a write current that flows through a write bit line and has been applied to a write current that flows through a write word line, these cases can be used by combining them.

For example, in the case where data is continuously written into a memory cell which belongs to one row, a predetermined write word line is kept to be in a selected state, and write bit lines can be sequentially selected on a one by one basis.

In such a case, a state in which a write word line has been always changed is established, whereas charging and discharging are repeated with respect to a write bit line. Therefore, in particular, an embodiment in which the aspect of the present invention has been applied to the write current that flows through the write bit line becomes effective.

While the aspect of the present invention relates to a magnetic random access memory which carries out writing by utilizing a magnetic field (current magnetic field) generated by a write current, there is no limitation to the number of write lines relevant to one MTJ element.

For example, this example can be applied to: a single-axis system for carrying out writing by using only a write current that flows through one write line; a two-axis system for allocating an MTJ element at a cross point of two write lines which cross each other; and a three-axis system using three write lines.

### 3. Example of circuit

As has been described in the foregoing embodiments, the aspect of the present invention featured by ON/OFF control at the initial time of a write operation of an N-channel MOS transistor serving as a sinker or an N-channel MOS transistor serving as a transfer gate between a sink side common power supply line and a write line.

Here, a description will be given with respect to an example of a controller which generates a control signal SWN_R for determining ON/OFF operations of these N-channel MOS transistors.

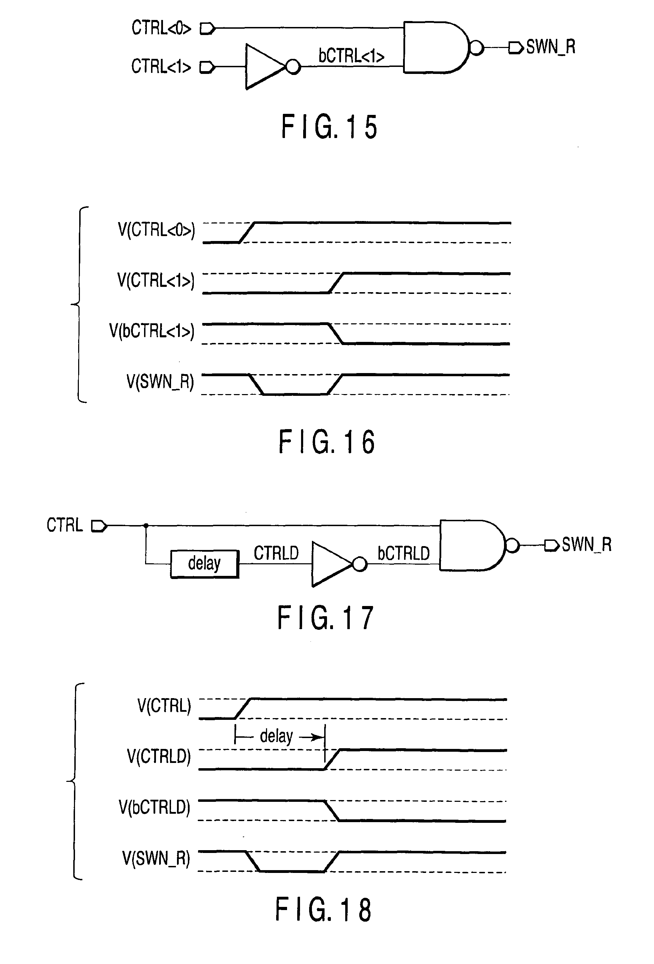

FIG. 15 shows an example of a logic circuit which generates a control signal SWN_R from two control signals CTRL<0> and CTRL<1>. FIG. 16 shows an operating waveform of the logic circuit shown in FIG. 15.

In this example, there is shown an example of a circuit which generates a pulse signal SWN_R by two in-phase control signals CTRL<0>/CTRL<1>. When a voltage level V(CTRL<0>) of the control signal CTRL<0> changes from "L" to "H", a voltage level V(SWN_R) of the control signal SWN_R changes from "H" to "L". Then, when a voltage level V(CTRL<1>) of the control signal CTRL<1> changes from "L" to "H", the voltage level V(SWN_R) of the control signal SWN_R changes from "L" to "H".

FIG. 17 shows an example of a logic circuit which generates a control signal SWN_R from one control signal CTRL. FIG. 18 shows an operating waveform of the logic circuit shown in FIG. 17. In this example, when a voltage level V(CTRL) of the control signal CTRL changes from "L" to "H", a voltage level V(SWN_R) of a control signal SWN_R changes from "H" to "L". Then, after a delay time determined by a delay circuit "delay" has elapsed, when a voltage level V(CTRLD) of a control signal CTRLD changes from "L" to "H", the voltage level V(SWN_R) of the control signal SWN_R changes from "L" to "H".

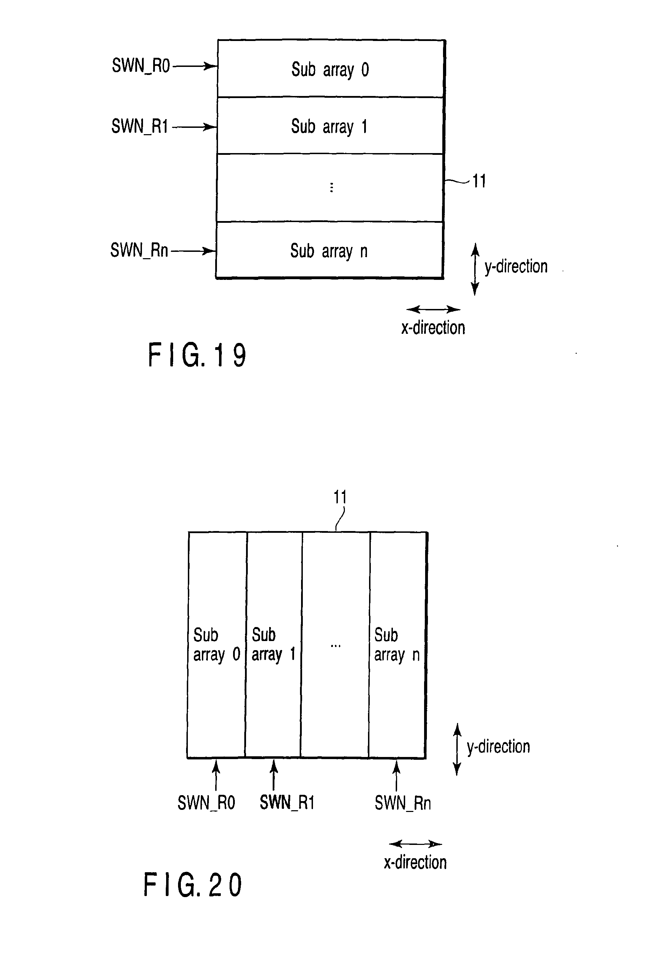

FIGS. 19 and 20 each show an example of a memory cell array.

A memory cell array 11, as shown in these figures, may be composed of a plurality of sub-arrays (or blocks). In such a case, let us consider an example in which a common power supply line has been provided on a sub-array by sub-array basis.

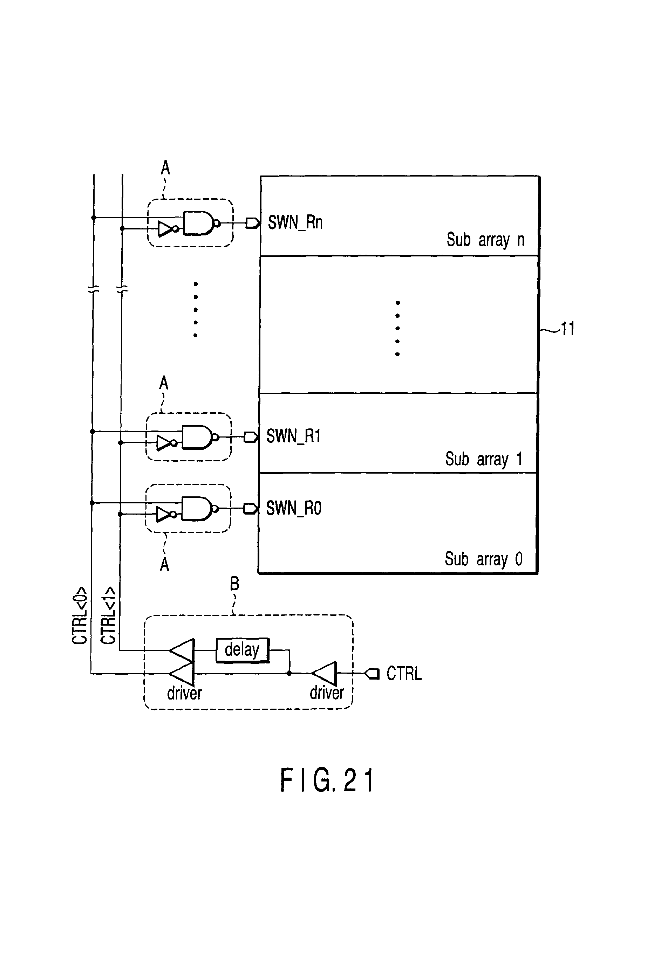

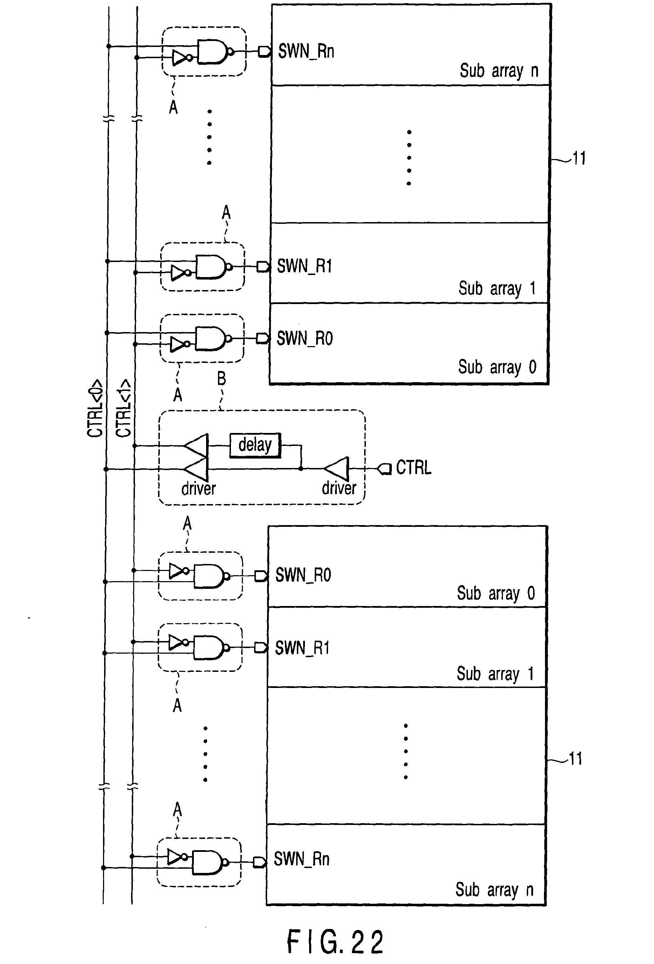

In this case, for example, as shown in FIGS. 21 and 22, logic circuits A shown in FIG. 15 are allocated to be associate with sub-arrays 0, 1, ... n. A respective one of the plurality of allocated logic circuits A generates a control signal SWN_Ri (i = 0, 1, ... n) based on control signals CTRL<0> and CTRL<1>.

Logic circuits B each generates control signals CTRL<0> and CTRL<1> based on a control signal CTRL.

FIG. 21 shows an example in which logic circuits B have been allocated at one side of a plurality of sub-arrays, and FIG. 22 shows an example in which logic circuits B have been allocated at the center of a plurality of sib-arrays.

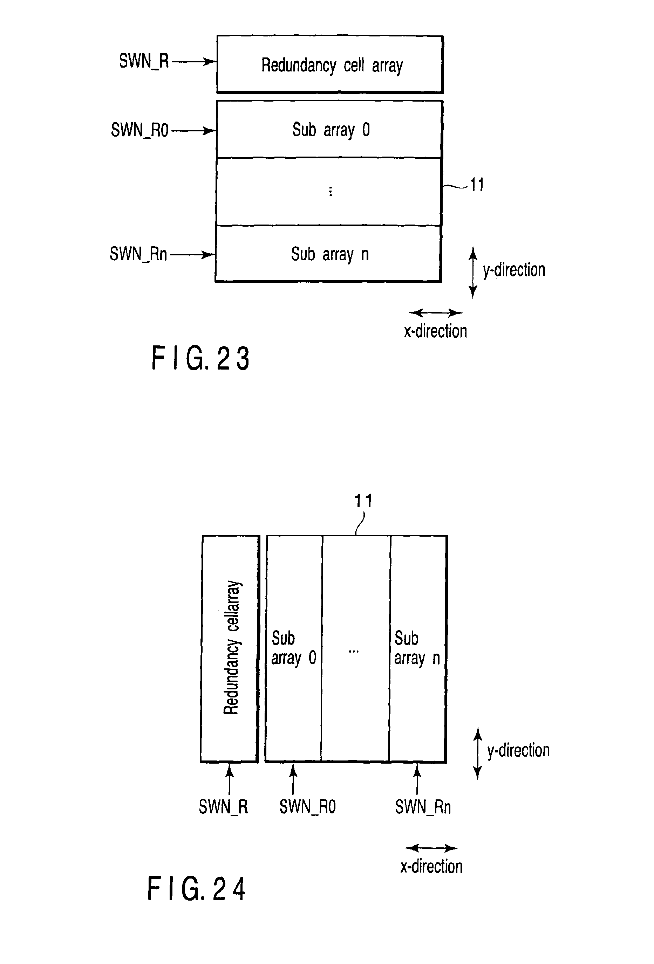

FIGS. 23 and 24 each show an example of allocation of a memory cell array in the case where a so-called block redundancy system has been applied, the system having a redundancy cell array in addition to a general cell array.

Although it is possible to consider that the redundancy cell array corresponds to one of the sub-arrays 0, 1, ... n shown in FIGS. 19 and 20, the writing method according to the aspect of the present invention may not be applied to this redundancy cell array. This is because the size (memory capacity) of the redundancy cell array is generally smaller than that of a memory cell array (including sub-arrays or blocks).

For example, let us consider a 1Mb cell array whose memory cell array is composed of 1024 x 1024 bits, and consider a case where a block redundancy system has been applied to row redundancy. In this case, in general, a bit line length of the redundancy cell array, namely, the number of word lines crossing one bit line is, for example, 128, which is smaller than that of a general memory cell array. For example, in this case, the bit line length of the redundancy cell array is, in general, 1/8 of that of the memory cell array. As a result, a parasitic capacity and a wiring resistance of a bit line in the redundancy cell array is, in general, smaller than that of the memory cell array (in this example, each of them is 1/8). Therefore, in the redundancy cell array, in general, charging and discharging of a write line can be carried out at a high speed, as compared with the memory cell array. Therefore, a high speed write operation can be made even if the present invention is not applied.

However, this is a mere comparison-based logic, and, of course, in the case where further high speed writing is required for the redundancy cell array as well, in general, the aspect of the present invention can be applied to the redundancy cell array as is the case with the memory cell array.

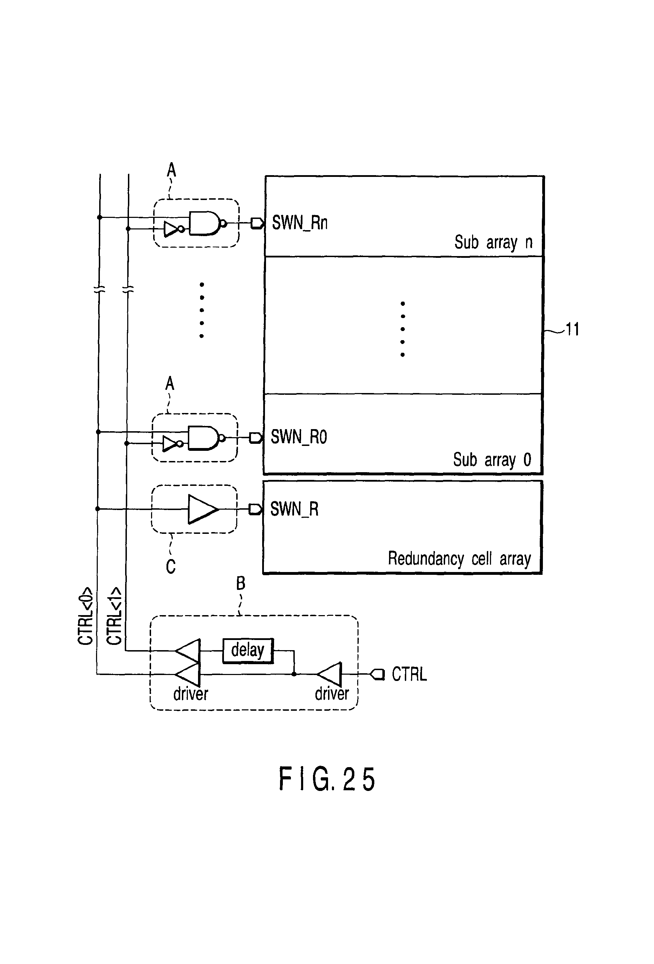

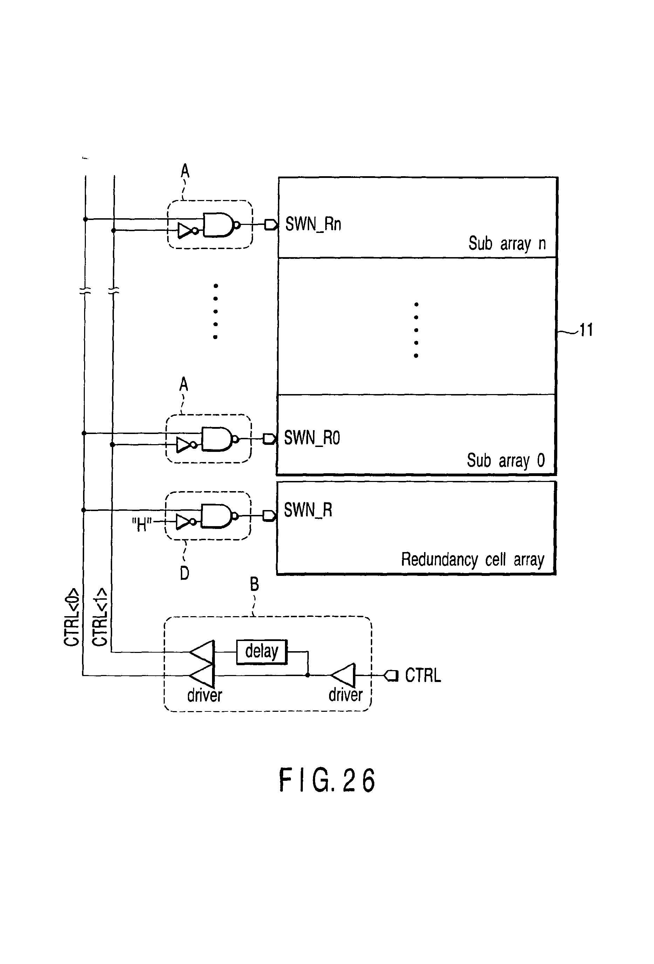

FIGS. 25 and 26 each show an example of a logic circuit in the case where the aspect of the present invention is not applied to a redundancy cell array. FIG. 25 shows an example of allocating dedicated control circuits C for the redundancy cell array, wherein the control circuits C are provided as circuits for re-driving CTRL<0>. FIG. 26 shows an example of using the same control circuits A in the redundancy cell array and in a general memory cell array, wherein an "H" signal (Vdd) is inputted to the control circuits A for the redundancy cell array instead of the control signal CTRL<1>.

In the case of the example shown in FIG. 25, a control signal SWN_R outputted from the logic circuits C corresponding to the redundancy cell array changes depending on only a control signal CTRL<0>, and does not depend on a control signal CTRL<1>.

That is, in the logic circuits C, when the control signal CTRL<0> is set to "H", the control signal SWN_R is set to "H", and when the control signal CTRL<0> is set to "L", the control signal SWN_R is set to "L".

In the case of an example shown in FIG. 26, a control signal SWN_R outputted from the logic circuits A corresponding to the redundancy cell array is set to "H", regardless of the control signals CTRL<0> and CTRL<1>.

According to such a logic circuit, with a simple configuration, the writing method according to the aspect of the present invention can be applied to only a memory cell array by dividing the memory cell array and the redundancy cell array.

### 4. Example of application

The writing method according to the aspect of the present invention can be applied regardless of a type of magnetic random access, for example, a structure of a memory cell array such as a cross point type memory cell.

In applying the aspect of the present invention, a structure, a shape and the like of a magneto-resistive effect element are not limited in particular.

### 5. Others

According to the aspect of the present invention, a sink side end of a write bit/word line is established in a floating state prior to supplying a write current to a write bit/word line, and then, a write current is supplied while the sink side end of the write bit/word line is connected to a grounding point.

Therefore, a rise waveform of the write current can be made steep, and a time from a standby state to a steady state in which the write current is established can be reduced. In this manner, a write speed of the magnetic random access memory can be increased.

## Claims

1. A writing method of a semiconductor memory device which writes in using a magnetic field generated by a writing current, **characterized by** comprising:
connecting a write line (WL, BL) to a first power supply line (Vdd), and connecting one end of the write line to a second power supply line (Vss) after starting charging of the write line; and
supplying the write current to the write line to carry out data writing.

2. The writing method according to claim 1, **characterized in that** the charging is carried out by setting one end of the write line (WL, BL) in a floating state and supplying a charge from the first power supply line (Vdd) to the other end of the write line.

3. The writing method according to claim 1, **characterized in that** the charging is carried out by supplying a charge from the first power supply line (Vdd) to both of one end and the other end of the write line.

4. The writing method according to claim 1, **characterized in that**, while the charging is carried out, the write line (WL, BL) turns OFF a switch (17, 20, 24) connected to the second power supply line (Vss).

5. The writing method according to claim 1, **characterized in that**, while the charging is carried out, a transfer gate (16, 19, 22) connected to one end of the write line is turned OFF.

6. The writing method according to claim 1, **characterized in that**, in the case where the semiconductor memory device has a redundancy cell array, a write current is supplied to a write line in the redundancy cell array without carrying out the charging with respect to memory cells in the redundancy cell array, thereby carrying out the writing.

7. The writing method according to claim 1, **characterized in that** the semiconductor memory device comprises a transfer gate (12, 19, 22) having a first node connected to the first power supply line (Vdd) and a second node connected to the other end of the write line (WL, BL), and the charging is executed until a voltage between the first node and the second node.

8. The writing method according to claim 5, **characterized in that** the transfer gate is a MOS transistor, and the predetermined value is a threshold voltage of the transfer gate.

9. A semiconductor memory device comprising:
a writing line (WL, BL);
first and second power supply lines (Vdd, Vss);
a first transfer gate (12, 19) which is connected between one end of the write line and the first power supply line;
a second transfer gate (, 16, 22) which is connected between the other end of the write line and the second power supply line; and
a control circuit (26) which connects the write line to the first power supply line, connects the write line to the second power supply line after starting charging of the write line, and carries out data writing by supplying a write current to the write line.

10. The magnetic random access memory according to claim 9, **characterized in that** the charging is carried out by setting one end of the write line (WL, BL) in a floating state and supplying a charge from the first power supply line (Vdd) to the other end of the write line.

11. The magnetic random access memory according to claim 9, **characterized in that** the charging is carried out by supplying a charge from the first power supply line (Vdd) to both of one end and the other end of the write line (WL, BL).

12. The magnetic random access memory according to claim 9, **characterized by** further comprising:
a first write driver/sinker (20) which is connected to the first transfer gate; and
a second driver/sinker (24) which is connected to the second transfer gate.

13. The magnetic random access memory according to claim 12, **characterized in that** the write line is a write bit line (BL) in which a direction of the write current changes in response to a value of write data.

14. The magnetic random access memory according to claim 9, **characterized by** further comprising:
a driver (14) which is connected to the first transfer gate; and
a sinker (17) which is connected to the second transfer gate.

15. The magnetic random access memory according to claim 14, **characterized in that** the write line is a write word line (WL) in which the write current flows in an always one direction without relation to a value of write data.

16. The magnetic random access memory according to claim 9, **characterized by** further comprising:
a first clamping circuit (N3) which is connected to one end of the write line and the second power supply line; and
a second clamping circuit (N3) which is connected to the other end of the write line and the second power supply line.

17. The magnetic random access memory according to claim 9, **characterized in that**, while the charging is carried out, a switch which connects the write line (WL, BL) to the second power supply line (Vss) is turned OFF.

18. The magnetic random access memory according to claim 9, **characterized in that**, while the charging is carried out, the second transfer gate (16, 19, 22) is turned OFF.

19. The magnetic random access memory according to claim 9, **characterized in that** the first transfer gate (12, 19, 22) is a MOS transistor, and the charging is executed until a voltage between a source and a drain of the MOS transistor becomes a predetermined value.

20. The magnetic random access memory according to claim 19, **characterized in that** the predetermined value is a threshold value of the MOS transistor.
